# EUROPEAN PATENT APPLICATION

(11) **EP 2 858 088 A1**
(43) Date of publication of application: **08.04.2015**
(21) Application number: 13800490.8
(22) Date of filing: 28.02.2013
(51) Int. Cl.: H01J 47/06, G01T 1/18

(54) **GLASS SUBSTRATE FOR ELECTRONIC AMPLIFICATION, AND METHOD FOR MANUFACTURING GLASS SUBSTRATE FOR ELECTRONIC AMPLIFICATION**

(30) Priority: 05.06.2012 JP 2012127905
(71) Applicant: HOYA Corporation, Tokyo 161-8525 (JP)
(72) Inventor: FUSHIE Takashi, Tokyo 161-8525 (JP); KIKUCHI Hajime, Tokyo 161-8525 (JP)
(74) Representative: Betten & Resch
(86) International application number: PCT/JP2013/055355
(87) International publication number: WO 2013/183324

(57) **Abstract**

There is provided a glass substrate (15) for electronic amplification having through holes (14) formed on a plate-like glass member (11) and used for causing an electron avalanche in the through holes (14), wherein a shape of the glass substrate (15) for electronic amplification and a material of the glass member (11) are determined so that an insulation resistance in a plate thickness direction per plane of 100 cm² is 10⁷ to 10¹¹Ω.

## Description

### Field of the Invention

The present invention relates to a glass substrate for electronic amplification and a method for manufacturing the same.

### Description of Related Art

In recent years, a detector for detecting particle beams or electromagnetic waves utilizing electron avalanche amplification by a gas electron multiplier (abbreviated as "GEM" hereafter), is known.

A general GEM has a plurality of through holes formed on a plate-like film member made of polyimide, etc. , so as to pass through its front and rear surfaces, and has a substrate for electronic amplification with both surfaces of its film member coated with copper. Then, potential difference is applied between two electrodes using a copper thin film coating both surfaces of the film member in a state that the substrate for electronic amplification is disposed in a detection gas. Then a strong electric field is created in the plurality of through holes, and an electron avalanche amplification is caused by this electric field to increase the ionization electron number so as to be regarded as a signal, to thereby measure the ionization electrons in the detection gas (for example, see patent document 1).

However, in the GEM having the abovementioned structure, the film member made of polyimide, etc., is used as a base material of the substrate for electronic amplification, thus involving a problem that heat resistance, smoothness, and stiffness, etc., are low and an outgas is easily generated. Therefore, regarding the detector for detecting the particle beams or the electromagnetic beams, use of a glass substrate made of a lead-free soda-lime-silica glass (for example, see patent document 2) or a glass substrate made of an inorganic material such as a heat-resistant glass, etc. , (for example, see patent document 3), etc. , is proposed.

### Prior Art Document

### Patent Document

Patent document 1: JP-A-2006-302844
Patent document 2: Patent Publication No.4058359
Patent document 3: JP-A-2009-301904

### Summary of the Invention

### Problem to be solved by the Invention

Incidentally, in the substrate for electronic amplification for the use of the detector of the particle beams or the electromagnetic waves, "discharge" or "charge-up" is a big problem.

The "discharge" occurs by breakage of the insulation, thereby short-circuiting between two electrodes on front and rear sides of the substrate. Such an occurrence of the "discharge" possibly leads to a destruction of an electric circuit, etc., that reads a signal of the ionization electron number. Further, the "charge-up" occurs by charging of the substrate. Such an occurrence of the "charge-up" possibly leads to a situation that a desired electronic gain cannot be obtained due to adsorption of the electrons on the substrate.

Thus, both of the "discharge" and the "charge-up" are possibly a factor of an instable operation of the detector, and therefore the occurrence of the "discharge" and "charge-up" should be avoided previously.

In this point, when the glass substrate is used as the base material of the substrate for electronic amplification, a volume resistivity of the base material is low compared with a case of using the film member made of polyimide, etc., and therefore use of the glass substrate is effective for suppressing the occurrence of the "charge-up". However, the occurrence of the "charge-up" is greatly affected by not only the volume resistivity of the base material, but also a surface resistivity of the substrate after forming the through holes. Accordingly, the occurrence of the "charge-up" cannot be necessarily effectively suppressed only by using the glass substrate as the base material of the substrate for electronic amplification. Also, the same thing can be said for the occurrence of the "discharge", and even when the glass member is used as the base material of the substrate for electronic amplification, the occurrence of the "discharge" is required to be effectively suppressed. Namely, in each case of the "discharge" and the "charge-up", it cannot be said that the glass substrate is suitable for the use for the detector of particle beams or electromagnetic waves, unless the occurrence of the "discharge" and "charge-up" is effectively suppressed.

Therefore, an object of the present invention is to provide an electron amplification glass substrate and a method for manufacturing the same capable of effectively suppressing the occurrence of both of the "discharge" and the "charge-up" even when the glass substrate is used as the base material of the substrate for electronic amplification.

### Means for solving the Problem

In order to solve the above-described problem, the present invention is provided, and in order to achieve the object of the present invention, inventors of the present invention study on an occurrence factor of the "discharge" and the "charge-up". "Discharge" occurs by an electrical flow in a short circuit in a plate thickness direction of the glass substrate, and easily occurs when the insulation resistance is excessively small particularly in the plate thickness direction. Also, "charge-up" occurs by charging of the glass substrate and easily occurs when the insulation resistance is excessively large particularly in the plate thickness direction of the glass substrate. Thus, it is found by the inventors of the present invention, that the occurrence of both of the "discharge" and the "charge-up" can be effectively suppressed if the insulation resistance in the plate thickness direction of the glass substrate falls in a specific range without being excessively large or small.

However, the insulation resistance in the plate thickness direction of the glass substrate affects the volume resistivity of the glass member constituting the glass substrate, and the surface resistivity of the glass substrate. Then, it can be considered that the surface resistivity called here, is largely affected by a formation mode of the through holes (for example, the number of formation of the through holes, hole diameter, and hole length, etc.) As a result of strenuous efforts of the inventors of the present invention regarding these points, a knowledge is obtained such that the glass substrate must be constituted so that the insulation resistance in the plate thickness direction falls in a specific range, in consideration of the formation mode of the through holes that largely affects the surface resistivity, namely the formation of the glass substrate having the through holes formed thereon, other than a material of the glass member that determines the volume resistivity.

The present invention is provided based on the above-described new knowledge obtained by the inventors of the present invention.

According to a first aspect of the present invention, there is provided a glass substrate for electronic amplification having through holes formed on a plate-like glass member and used for causing an electron avalanche in the through holes, wherein a shape of the glass substrate for electronic amplification and a material of the glass member are determined so that an insulation resistance in a plate thickness direction per plane of 100 cm² is 10⁷ to 10¹¹Ω.

According to a second aspect of the present invention, there is provided the glass substrate for electronic amplification of the first aspect, wherein the shape is specified by at least one of the number of the through holes formed on the glass member, the hole diameter of each through hole, and a plate thickness of the glass member.

According to a third aspect of the present invention, there is provided the glass substrate for electronic amplification of the second aspect, wherein the shape includes a state of a surface roughness on an inner wall surface of the through hole.

According to a fourth aspect of the present invention, there is provided the glass substrate for electronic amplification of the first, second, or third aspect, wherein a photosensitive glass is used as the material of the glass member.

According to a fifth aspect of the present invention, there is provided a method for manufacturing a glass substrate for electronic amplification having through holes formed on a plate-like glass member and used for causing an electron avalanche in the through holes, the method including:
measuring an insulation resistance value in a plate thickness direction of a measured object per plane of 100 cm² of the measured object, using a glass substrate for electronic amplification having the through holes formed on the glass member, as the measured object; and
judging a quality of the measured object whose measurement result is obtained, based on whether or not the measurement result of the insulation resistance value falls in a range of 10⁷ to 10¹¹ Ω when measuring the resistance.

### Advantage of the Invention]

According to the present invention, even in a case of using the glass substrate as the base material of the substrate for electronic amplification, the occurrence of both of the "discharge" and the "charge-up" can be effectively suppressed.

### Brief description of the drawings

FIG. 1 is an explanatory view showing a schematic constitutional example of a detector according to an embodiment of the present invention.
FIG. 2 is an explanatory view showing an example of a manufacturing procedure of a substrate for electronic amplification according to an embodiment of the present invention.

### Detailed description of the Invention

An embodiment of the present invention will be described hereafter, based on the drawings.

In this embodiment, an explanation is divided into the following items in this order.
1. Schematic structure of a detector
2. Structure of a glass substrate for electronic amplification
3. Manufacturing procedure of a substrate for electronic amplification
4. Measurement procedure of ionization electrons in the detector
5. Effect of this embodiment
6. Modified example, etc.

### <1. Schematic structure of a detector>

First, a schematic structure of a detector of this embodiment will be described.

The detector is configured to measure ionization electrons utilizing an electron avalanche amplification in a detection gas, thus detecting particle beams or electromagnetic waves.

The "electron avalanche amplification" used by the detector, is a phenomenon in which if free electrons collide with gas molecules in a strong electric field, a new electron is knocked-out, which is then accelerated in the electric field and the knocked-out electrons further collide with another molecule, to thereby increase the number of electrons with increasing speed. The detector utilizing the electron avalanche amplification includes for example a Capillary Gas Proportional Counter; CGPC, and in this embodiment, the detector causes the electron avalanche amplification using GEM.

Wherein, the "GEM" is configured to create a strong electric field in the through hole of the substrate for electronic amplification in a state that the substrate for electronic amplification is disposed in the detection gas, the substrate having a plurality of two-dimensionally arranged fine through holes, so that the electron avalanche amplification is caused by this electric field. The substrate for electronic amplification may be a single plate-like substrate or may be a multiple layered substrate.

The "particle beams" that can be an object to be detected by the detector, include alpha rays, beta rays, proton rays, heavy charged particle rays, electron beams (which accelerate electrons by an accelerator regardless of a nuclear decay), neutron beams, and cosmic ray, etc. Also, the "electromagnetic waves" include a radio wave (low-frequency, ultra-long wave, long wave, medium wave, short wave, VHF, microwave), and also include a light (infrared light, visible light, and ultraviolet light), W-rays, and gamma rays, etc. Which one of them is selected to be detected, can be set to a desired one by suitably selecting the kind of the detection gas and intensity of the created electric field.

The detector of this embodiment as described above, namely the detector configured to detect the particle beams or the electromagnetic waves by utilizing the electron avalanche amplification by GEM, is specifically configured as described below.

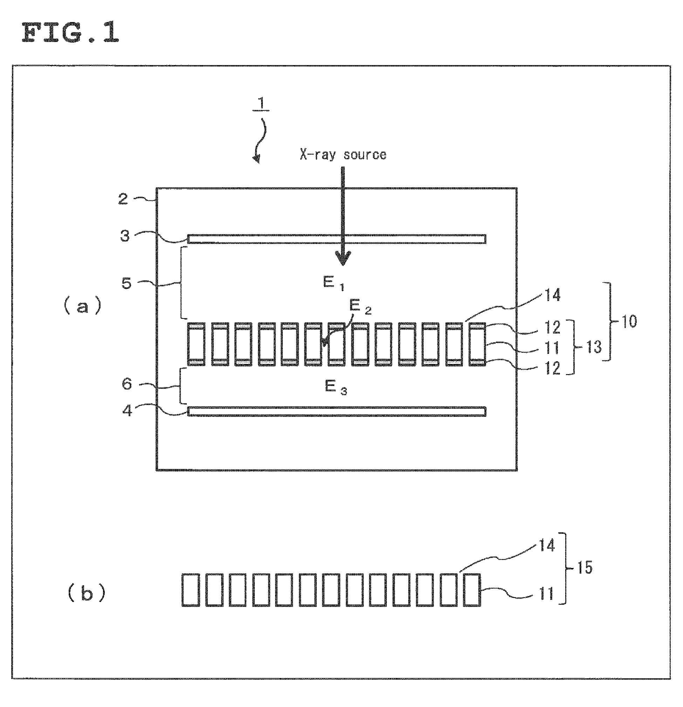

FIG. 1 is an explanatory view showing an example of a schematic structure of the detector of this embodiment.

As shown in FIG. 1(a), a detector 1 of this embodiment includes a drift electrode 3 and a readout electrode 4 in a chamber 2 filled with a prescribed kind of detection gas, and also includes a substrate 10 for electronic amplification disposed between the drift electrode 3 and the readout electrode 4. The substrate 10 for electronic amplification causes electron avalanche amplification and realizes a function of GEM, wherein a plurality of through holes 14 are two-dimensionally arranged on a lamination body 13 in which conductive layers 12 are formed on both surfaces of a plate-like member 11. Each one of the plurality of through holes 14 has a circular shape in planar view, and arranged at a constant interval. The chamber 2 is configured to allow the particle beams or the electromagnetic waves to be incident therein from outside (for example, see "X-RAY SOURCE" shown in the figure).

A specific voltage is applied from a power supply section not shown, to the drift electrode 3 and the readout electrode 4 in the chamber 2. Also, the specific voltage is applied from the power supply section not shown, to each conductive layer 12 on both surfaces of the substrate 10 for electronic amplification, by a function of each conductive layer 12 as an electrode. Owing to such a voltage application from the power source section, an electric field E1 is generated in a region (called a "drift region" hereafter) between the drift electrode 3 and the substrate 10 for electronic amplification, and an electric field E3 is generated in a region 6 (called an "induction region" hereafter) between the substrate 10 for electronic amplification and the readout electrode 4. Also, an electric filed E2 is generated in the through hole 14 of the substrate 10 for electronic amplification. Then, the electric field E2 is converged in the through hole 14, and the electrons entered into the hole are accelerated, to thereby generate the electron avalanche amplification. The detector 1 is configured to measure the electrons amplified by the electron avalanche amplification by the readout electrode 4, and output a measurement result thereof through an electric circuit, etc., for reading a signal not shown connected to the readout electrode 4.

In the detector 1 configured as described above, the plate-like member 11 constituting the substrate 10 for electronic amplification is a base material of the substrate 10 for electronic amplification, and therefore as described above, a glass member is used for forming the substrate, and in this case as well, preferably the occurrence of the "discharge" and the "charge-up" can be suppressed. Therefore, in the detector 1 of this embodiment, the substrate 10 for electronic amplification is configured using a glass substrate 15 for electronic amplification constituted as described below.

### <2. Structure of the substrate for electronic amplification>

Next, the structure of the glass substrate 15 for electronic amplification of this embodiment will be described.

### (Basic structure)

As shown in FIG. 1(b), the glass substrate 15 for electronic amplification, is provided with a plurality of through holes 14 two-dimensionally arranged on the plate-like member 11 which is formed by the glass member, wherein glass capillaries (capillaries) are bundled regularly in parallel, which is then formed into a plate-shape, so that an electron avalanche amplification action can be caused particularly in the gas. Namely, the glass substrate 15 for electronic amplification is provided with the through holes 14 on the plate-like member 11 which is a plate-like glass member, and is used for causing the electron avalanche amplification to occur in the through hole 14. When the conductive layers 12 that function as the electrode, are formed on the front and rear surfaces of the glass substrate 15 for electronic amplification, the substrate 10 for electronic amplification is constituted (see FIG. 1 (a)).

In the glass substrate 15 for electronic amplification thus configured, the plate-like member 11 is formed by the glass member having insulation property. Accordingly, such a plate-like member 11 has excellent heat resistance, smoothness, and rigidity, etc., compared with a case of using a resin material such as polyimide like a general GEM, and there is no problem of outgas.

However, there is a necessity for providing the through holes 14 having a fine hole diameter at an arrangement pitch so as to be hardly formed by a mechanical machining such as a fine powder injection method, etc. Therefore, the plate-like member 11 is formed by a photosensitive glass, so that the through holes 14 can be provided by utilizing a fine machining technique used in a semiconductor manufacturing process.

The "photosensitive glass" is the glass containing little amounts of Au, Ag, Cu as photosensitive metals and further containing CeO₂ as a sensitizer in a SiO₂-Li₂O-Al₂O₃ based glass. By irradiating the photosensitive glass with ultraviolet rays, oxidation-reduction reaction occurs, and metal atoms are generated. Upon further heating, the metal atoms are aggregated to form a colloid, and a crystal of Li₂O/SiO₂ (lithium metasilicate) grows with the colloid as a nucleus. The Li₂O/SiO₂ (lithium metasilicate) precipitated here is easily dissolved in HF, and there is a difference in a dissolving speed of about 50 times compared with a glass portion not irradiated with the ultraviolet rays. Selective etching can be performed by utilizing such a difference in a dissolving speed, and a fine workpiece can be formed without using the mechanical machining. For example, "PEG3 (product name)" by HOY Corporation can be given as such a photosensitive glass.

Note that the "PEG3" is not necessarily given as the photosensitive glass forming the plate-like member 11, and the plate-like member 11 can also be formed by other photosensitive glass. As an example thereof, a photosensitive crystallized glass obtained by crystallizing the photosensitive glass can be given as other photosensitive glass.

The "photosensitive crystallized glass" is the glass in which a fine crystal is evenly precipitated by applying heat treatment to the photosensitive glass (heat treatment under a different condition from the case of the fine processing performed to the photosensitive glass). The crystal precipitated here is excellent in chemical durability, unlike the crystal of Li₂O/SiO₂ (lithium metasilicate). Accordingly, the photosensitive crystallized glass is in a polycrystalline state in which crystallization is completely advanced, and therefore has an advantage that it has excellent mechanical property compared with an amorphous solid photosensitive glass. For example, "PEG3C (product name)" by HOYA Corporation can be given as such a photosensitive crystallized glass.

The photosensitive glass "PEG3" has a volume resistivity of about 8.5 × 10¹² Ωcm. Also, the photosensitive crystallized glass "PEG3C" has a volume resistivity of about 4.5 × 10¹⁴Ωcm. Accordingly, since the volume resistivity is lower than that of polyimide, etc. , having the volume resistivity of 10¹⁵ Ωcm or more, the "PEG3C" is a hardly charged material.

### (Insulation resistance)

Incidentally, the glass substrate 15 for electronic amplification having the abovementioned structure is sued for the detector 1 that detects the particle beams or the electromagnetic waves by utilizing the electron avalanche amplification, and therefore the occurrence of the "discharge" or the "charge-up" is a big problem.

The "discharge" occurs by a short-circuit flow of electricity in a plate thickness direction of the glass substrate 15 for electronic amplification, and easily occurs particularly when the insulation resistance in the plate thickness direction is excessively small. Also, the "charge-up" occurs by charging of the substrate 15 for electronic amplification, and easily occurs particularly when the insulation resistance in the plate thickness direction of the glass substrate 15 for electronic amplification is excessively large. Accordingly, in order to effectively suppress the occurrence of the "discharge" and the "charge-up", it can be considered that the insulation resistance in the plate thickness direction of the glass substrate 15 for electronic amplification falls in a specific range without being excessively small or excessively large.

As described above, the glass substrate 15 for electronic amplification of this embodiment is configured so that the insulation resistance in the plate thickness direction per plane of 100 cm² is 10⁷ to 10¹¹Ω. This is because if the insulation resistance per plane of 100 cm² is less than 10⁷Ω, electricity easily flows in the plate thickness direction of the glass substrate 15 for electronic amplification, and when the substrate 10 for electronic amplification is constituted, the occurrence of the "discharge" is recognized by an experimental rule obtained by an experiment, etc. Also, if the insulation resistance per plane of 100 cm² exceeds 10¹¹Ω, the glass substrate 15 for electronic amplification is easily charged, and when the substrate 10 for electronic amplification is constituted, the occurrence of the "charge-up" is recognized by an experimental rule obtained by an experiment, etc.

The "insulation resistance" in the substrate 15 for electronic amplification means an electric resistance (unit is Ω) between the conductive layers 12 on the front and rear surfaces (namely between electrodes insulated by the glass substrate 15 for electronic amplification which is an insulator) when the substrate 10 for electronic amplification is constituted, and is mainly specified by the volume resistivity and the surface resistivity of the substrate 15 for electronic amplification.

The "volume resistivity" means a physical amount (unit is Ω cm) specific to a certain substance. Accordingly, the volume resistivity in the glass substrate 15 for electronic amplification is determined by the material of the glass member constituting the plate-like member 11.

The "surface resistivity" means an electric resistance per unit area, and the unit is Ω/ or Ω/sq. In the case of the glass substrate 15 for electronic amplification, the surface area thereof is largely affected by the number of the through holes 14, the surface area and the surface state (roughness, etc.) of the wall surface in each through hole 14. Accordingly, the surface resistivity of the glass substrate 15 for electronic amplification is determined by the shape of the glass substrate 15 for electronic amplification. The "shape" of the glass substrate 15 for electronic amplification here is specified by shape constituent elements such as a plate thickness of the glass member constituting the plate-like member 11, the number of (or formation pitch) of the through holes 14 formed on the plate-like member 11, the hole diameter of each through hole 14, and a surface roughness state on the inner wall surface of the through hole 14, etc.

Namely, the insulation resistance of the glass substrate 15 for electronic amplification is mainly specified by the shape of the glass substrate 15 for electronic amplification, and the material of the glass member constituting the plate-like member 11. Accordingly, in the glass substrate 15 for electronic amplification of this embodiment, the shape of the glass substrate 15 for electronic amplification, and the material of the glass member constituting the plate-like member 11 are determined so that the insulation resistance in the plate thickness direction per plane of 100 cm² is 10⁷ to 10¹¹ Ω.

Specifically, for example the case of using the "PEG3" is considered, as the material of the glass member constituting the plate-like member 11. The volume resistivity of the "PEG3" is about 8.5 × 10¹² Ωcm. Therefore, when the "PEG3" is used, the surface resistivity of the glass substrate 15 for electronic amplification, namely the shape of the glass substrate 15 for electronic amplification specifying the surface resistivity is set so that the insulation resistance in the plate thickness direction per plane of 100 cm² of the glass substrate 15 for electronic amplification is 10⁷ to 10¹¹ Ω even when the volume resistivity is about 8.5 × 10¹² Ωcm. More specifically, at least one of the plate thickness of the plate-like member 11, the number of the through holes 14 formed on the plate-like member 11, and the hole diameter of each through hole 14 which are the shape constituent elements of the glass substrate 15 for electronic amplification, is set so that the insulation resistance falls in a range of 10⁷ to 10¹¹ Ω.

Further, for example the case of using the "PEG3C" is considered as the material of the glass member constituting the plate-like member 11. The volume resistivity of the "PEG3C" is about 4.5 × 10¹⁴ Ωcm. Therefore, when the "PEG3C" is used, the surface resistivity of the glass substrate 15 for electronic amplification, namely the shape of the glass substrate 15 for electronic amplification for specifying the surface resistivity is set so that the insulation resistance in the plate thickness direction per plane of 100 cm² of the glass substrate 15 for electronic amplification is 10⁷ to 10¹¹ Ω even when the volume resistivity is about 4.5 × 10¹⁴ Ωcm. More specifically, at least one of the plate thickness of the plate-like member 11, the number of the through holes 14 formed on the plate-like member 11, and the hole diameter of each through hole 14 which are the shape constituent elements of the glass substrate 15 for electronic amplification, is set so that the insulation resistance falls in the range of 10⁷ to 10¹¹ Ω.

Further, when the "PEG3C" is used, the state of the surface roughness on the inner wall surface of the through hole 14 is also included as the shape constituent element of the glass substrate 15 for electronic amplification. The surface state can be roughened by applying etching treatment to the photosensitive crystallized glass such as the "PEG3C", for removing only a specific kind of crystal from a crystal structure constituting the photosensitive crystallized glass. If the surface state is roughened, a fine irregularity is formed on the surface, and therefore a surface area is increased compared with a case of not roughening the surface, and electricity is hardly transmitted. Namely, the state of the surface roughness largely affects the surface resistivity. Accordingly, when the "PEG3C" is used, the state of the surface roughness on the inner wall surface of the through hole 14 is set as needed, so that the state of the surface roughness on the inner wall surface of the through hole 14 is included as the shape constituent element of the glass substrate 15 for electronic amplification, and the insulation resistance falls in the range of 10⁷ to 10¹¹ Ω.

Explanation is given in examples described later, for specifically which value is set as the shape constituent element of the glass substrate 15 for electronic amplification, so that the insulation resistance is set to 10⁷ to 10¹¹ Ω in the plate thickness direction per plane of 100 cm² of the glass substrate 15 for electronic amplification.

### <3. Manufacturing procedure of the substrate for electronic amplification>

Next, explanation is given for a manufacturing procedure of the substrate 10 for electronic amplification constituted by using the glass substrate 15 for electronic amplification as described above.

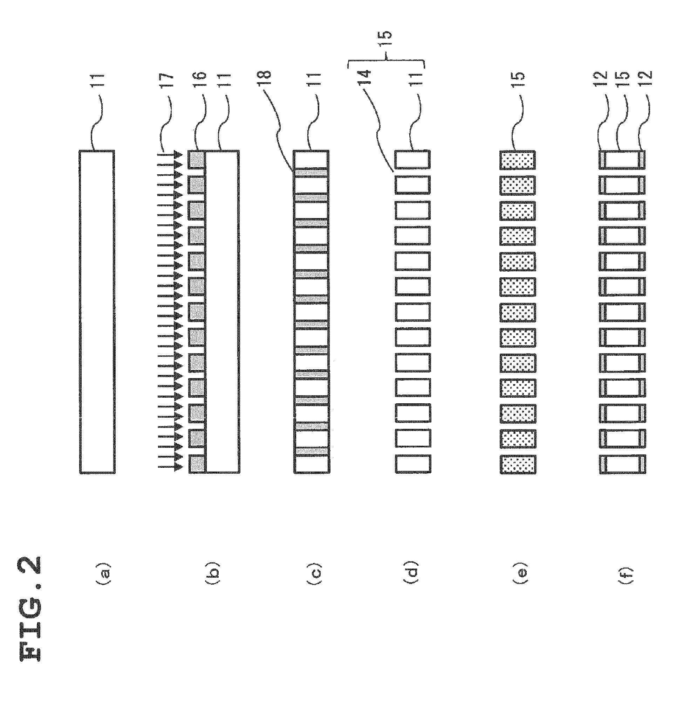

FIG. 2 is an explanatory view showing an example of the manufacturing procedure of the substrate for electronic amplification according to this embodiment.

In manufacturing the substrate 10 for electronic amplification, first, as shown in FIG. 2(a), a flat-shaped plate-like member 11 is prepared, which is formed into a desired thickness with a desired outer shape (for example, a rectangular shape of 300 mm × 300 mm) by the photosensitive glass such as the "PEG3", etc. The plate thickness of the plate-like member 11 is set to a desired thickness so that the insulation resistance of the glass substrate 15 for electronic amplification is 10⁷ to 10¹¹ Ω, because the plate thickness of the plate-like member 11 is one of the shape constituent elements of the glass substrate 15 for electronic amplification.

Then, as shown in FIG. 2(b), a photomask 16 with a desired pattern formed thereon, is superimposed on the prepared plate-like member 11, and the plate-like member 11 is irradiated with ultraviolet rays 17 through the photomask 16. Thus, the oxidation reduction reaction occurs at an UV irradiation site of the plate-like member 11, and the metal atoms are generated.

Thereafter, heat treatment is applied to the plate-like member 11 after irradiation of the UV-ray, for example at a temperature of 450 to 600°C. Then, as shown in FIG. 2(c), the metal atoms generated by UV-irradiation are aggregated to form a colloid on the plate-like member 11, and a crystal of Li₂O/SiO₂ (lithium metasilicate) grows with the colloid as a nucleus.

The Li₂O/SiO₂ (lithium metasilicate) precipitated here is easily dissolved in HF (hydrogen fluoride), and there is a difference in a dissolving speed of about 50 times compared with a glass portion not irradiated with the ultraviolet rays 17. Therefore, as shown in FIG. 2(d), after crystal growth by the heat treatment, etching is applied to the plate-like member 11 using HF. Thus, etching of removing a crystal portion 18 precipitated by heat treatment, namely selective etching is performed utilizing the difference of a dissolving speed with respect to the dissolving speed of HF. As a result, fine through holes 14 having almost the same precision as the pattern of the photomask 16 can be formed on the plate-like member 11 without using the mechanical machining.

The number of the through holes 14, the pitch of forming the through holes 14, and the hole diameter of each hole to be formed on the plate-like member 11, are determined depending on the pattern formed on the photomask 16. Accordingly, in forming the through holes 14 on the plate-like member 11, the photomask 16 in which the pattern is determined so that the insulation resistance of the glass substrate 15 for electronic amplification is 10⁷ to 10¹¹ Ω.

By passing through the above-described procedure, the glass substrate 15 for electronic amplification with through holes 14 formed on the plate-like member 11 made of the photosensitive glass such as "PEG3", etc., can be obtained. When the substrate 10 for electronic amplification is constituted using the glass substrate 15 for electronic amplification, the conductive layers 12 are formed on each of the front and rear surfaces of the glass substrate 15 for electronic amplification as described later in detail.

Further, when not the photosensitive glass such as "PEG3" but the photosensitive crystallized glass such as "PEG3C" is used as the formation material of the plate-like member 11, further heat treatment is applied to the glass substrate 15 for electronic amplification obtained by the above-described procedure (namely, the substrate made of the photosensitive glass such as "PEG3", etc.) The heat treatment at this time is performed under a condition different from the heat treatment for forming the through holes 14 performed previously. Specifically, for example heat treatment is performed at a temperature exceeding 1000°C. Thus, unlike the case of the previously performed heat treatment, the plate-like member 11 is set in a polycrystalline state in which fine crystals having excellent chemical durability are evenly precipitated in the glass and crystallization is completely advanced. This is the state corresponding to the photosensitive crystallized glass such as "PEG3C" obtained by crystallizing the photosensitive glass such as "PEG3", etc. Namely, by performing the heat treatment again under the condition different from the condition of the previously performed heat treatment, as shown in FIG. 2(e), the glass substrate 15 for electronic amplification with a plurality of through holes 14 formed on the photosensitive crystallized glass such as"PEG3C", etc., can be obtained. The glass substrate 15 for electronic amplification thus obtained is made of the photosensitive crystallized glass in a polycrystalline state, in which crystallization is completely advanced, and therefore has an advantage of excellent mechanical property compared with the case that it is made of the amorphous solid photosensitive glass.

After the glass substrate 15 for electronic amplification with the through holes 14 formed on the photosensitive crystallized glass such as "PEG3C" is obtained, roughening of the surface state is performed to the inner wall surface of each through hole 14 as needed. The roughening of the surface state is a surface treatment of changing the surface to a rough surface state, and more specifically the surface treatment of changing the surface roughness at a level of generating a difference that can be recognized by SEM (electron microscope) observation or more than this level. The roughening of the surface state may be performed to at least the inner wall surface of the through hole 14, but may also include the front and rear surfaces and side edge, etc., of the plate-like member 11 other than the inner wall surface.

Roughening of the surface is performed by the following method. In this embodiment, the through hole 14 is formed, and etching is applied to the plate-like member 11 after crystallization, using an etching solution in which ammonium fluoride (NH₄F/HF) and ammonium sulfate ((NH₄)₂SO₄) are mixed at a specific ratio. By performing such an etching, crystal that is easily solved in the etching solution (for example, quartz) in each kind of crystals constituting the plate-like member 11, is preferentially selectively dissolved and removed. As a result, a plurality of fine etching marks are formed on the surface subjected to etching treatment (including the side wall surface of the through hole 14). Due to such a formation of the etching marks, the inner wall surface of the through hole 14 is roughened.

Regarding the roughened surface, fine irregularity is formed compared with a case of not performing roughening, and therefore electricity is hardly transmitted by increase of the surface area. Then, difficulty of transmission of electricity, namely the level of the surface resistivity is determined by the state of the surface roughness, more specifically by formation level of the fine irregularity (irregularity level to be formed). Accordingly, when roughening of the inner wall surface of the through hole 14 is performed, the time for performing etching treatment is set so that the insulation resistance of the glass substrate 15 for electronic amplification is 10⁷ to 10¹¹ Ω as the surface state (irregularity level to be formed).

Roughening of the inner wall surface of the through hole 14 is not necessarily required to be performed by the abovementioned etching treatment, and for example other method such as a mechanical polishing may also be used.

After obtaining the glass substrate 15 for electronic amplification in which the photosensitive glass such as "PEG3", etc., or the photosensitive crystallized glass such as "PEG3C", etc., is used through the abovementioned procedure, as shown in FIG. 2(f), a thin film of Cu, etc., or a laminated film of Cu and Cr, etc., are formed on each of the front and rear surfaces of the glass substrate 15 for electronic amplification by sputtering, to thereby form a conductive layer 12 in a thin film state (for example having a film thickness of about 2 µm). Thus, the substrate 10 for electronic amplification used for the detector of this embodiment is manufactured.

Thereafter, a resistance measurement step and a quality judgment step are performed to the glass substrate 15 for electronic amplification constituting the substrate 10 for electronic amplification.

In the resistance measurement step, an insulation resistance value in a plate thickness direction of a measured object per plane of 100 cm² of the measured object is measured, using the glass substrate 15 for electronic amplification constituting the substrate 10 for electronic amplification as the measured object. It can be considered that measurement of the insulation resistance value is performed by using the conductive layers 12 formed on the front and rear surfaces of the glass substrate 15 for electronic amplification for example, then measuring an electric resistance between the conductive layers 12 on the front and rear surfaces by an insulation resistance tester, etc. , and converting a result thereof to a plane of 100 cm².

Further, in the quality judgment step performed thereafter, quality judgment is performed to the measured object whose measurement result is obtained, based on whether or not the measurement result of the insulation resistance value obtained in the resistance measurement step falls in the range of 10⁷ to 10¹¹ Ω. Specifically, if the measurement result of the insulation resistance value falls in the range of 10⁷ to 10¹¹ Ω, the glass substrate 15 for electronic amplification which is the measured object, is judged to be a quality one. Meanwhile, if the measurement result of the insulation resistance value does not fall in the range of 10⁷ to 10¹¹ Ω, the glass substrate 15 for electronic amplification which is the measured object, is judged to be a defective one. As a result, only the substrate 10 for electronic amplification constituted using the quality glass substrate 15 for electronic amplification is delivered as a product.

In the resistance measurement step and the quality judgment step, the glass substrate 15 for electronic amplification in a state of a single body (namely in a state of not forming the conductive layers 12 on the front and rear surfaces) may be used as the measured object, if the measurement of the insulation resistance value can be performed without using the conductive layers 12.

### <4. Measurement procedure of ionization electrons in the detector>

Next, when a detector 1 is constituted using the substrate 10 for electronic amplification formed based on the glass substrate 15 for electronic amplification of this embodiment as described above, specific explanation is given with reference to FIG. 1, for a procedure of measuring the ionization electrons by the detector 1, thus measuring the particle beams or the electromagnetic waves. Wherein, explanation is given as follows, with a case of using the X-ray as a detection object as an example.

The chamber 2 of the detector 1 is filled with a specific kind of detection gas (for example mixed gas of Ar + CF₄). Further, a different magnitude of voltage is applied to the drift electrode 3, the readout electrode 4, and the conductive layers 12 of the substrate 10 for electronic amplification respectively so that electrons generated in a drift region 5 are read and attracted toward the readout electrode 4, to thereby generate electric fields E1, E2, and E3. Namely, voltage is applied to each of the drift electrode 3, the readout electrode 4, and the substrate 10 for electronic amplification so as to apply potential difference in such a manner that power of attracting electrons is larger toward the readout electrode 4.

If the X-ray is incident in the chamber 2 in this state, the gas is ionized by the incident X-ray and electrons are generated by such an ionization action in the drift region 5 of the chamber 2. At this time, since the electric field E1 is formed in the drift region 5, the generated electrons are attracted toward the substrate 10 for electronic amplification, and are ready to pass through the through hole 14 of the substrate 10 for electronic amplification.

However, a high electric field is generated by forming the electric field E2 in the through hole 14. Therefore, the speed of the electrons which are ready to pass through the through hole 14 is accelerated by the high electric field to increase a kinetic energy, thus adding energy to other circumferential electrons, to thereby release new electrons by an ionization action. This process is repeated, to thereby amplify the electrons, and ionization is continued in avalanche as a result. Namely, when the electrons are passed through the through hole 14, an electron avalanche amplification occurs.

At this time, even if the high electric field E2 is formed so as to allow the electron avalanche amplification to occur in the through hole 14, generation of the "discharge" and the "charge-up" can be suppressed, because the insulation resistance of the glass substrate 15 for electronic amplification is 10⁷ to 10¹¹ Ω as described above. For example, if the insulation resistance is less than 10⁷ Ω, electricity is easily flowed in the plate thickness direction of the glass substrate 15 for electronic amplification, thus involving a problem of generating the "discharge". However, if the insulation resistance is 10⁷ Ω or more as described in this embodiment, even if the high electric field E2 is formed, generation of the "discharge" can be suppressed. Also, for example, if the insulation resistance is larger than 10¹¹ Ω, the glass substrate 15 for electronic amplification is hardly charged, thus involving a problem of generating the "charge-up". However, if the insulation resistance is 10¹¹Ω or less as described in this embodiment, generation of the "charge-up" can be suppressed even if the high electric field E2 is formed.

The electrons amplified by the electron avalanche amplification in the through hole 14 are attracted toward the readout electrode 4 by the electric field E3 formed in an induction region 6, without generating both of the "discharge" and "charge-up". Then, the electron number is read by the readout electrode 4 as a signal. The readout electrode 4 that reads a signal, is divided into small areas. Therefore, an area in which electrons are measured, can be specified.

The detector 1 can detect the X-ray which is the detection object, by passing through the above-described procedure.

### <5. Effect of this embodiment>

According to the glass substrate 15 for electronic amplification and the method for manufacturing the same described in this embodiment, the following effect can be obtained.

In this embodiment, generation of both of the "discharge" and "charge-up" can be suppressed even if the high electric field E2 is formed so as to allow the electron avalanche amplification to occur in the through hole 14, because the insulation resistance of the glass substrate 15 for electronic amplification is 10⁷ to 10¹¹ Ω. Namely, factors that result in instability of an operation of the detector 1 such as "discharge" and "charge-up", etc., are eliminated. Accordingly, even in a case of detecting the particle beams or the electromagnetic waves using the detector 1, there is no situation that destruction of the electric circuit, etc., is caused by the generation of the "discharge" and a desired electron gain cannot be obtained by the generation of the "charge-up".

Further, in this embodiment, the shape of the glass substrate 15 for electronic amplification and the material of the glass member of the plate-like member 11 are selected so that the insulation resistance is 10⁷ to 10¹¹ Ω per plane of 100 cm². More specifically, the shape of the glass substrate 15 for electronic amplification is specified by the number of the through holes 14, the hole diameter of the through hole 14, and the plate thickness of the plate-like member 11. Accordingly, even when the insulation resistance of the glass substrate 15 for electronic amplification is specified by the volume resistivity and the surface resistivity and the surface resistivity is specified by a shape constituent element of the glass substrate 15 for electronic amplification, the insulation resistance can fall in the range of 10⁷ to 10¹¹ Ω.

Particularly, when the state of the surface roughness on the inner wall surface of the through hole 14 is included in the shape constituent elements of the glass substrate 15 for electronic amplification as described in this embodiment, the surface resistivity can be adjusted by the state of the surface roughness. Specifically, by roughening the surface state, the surface resistivity can be more increased than a case of not roughening the surface state. Accordingly, if the state of the surface roughness on the inner wall surface of the through hole 14 is included in the shape constituent elements of the substrate 15 for electronic amplification, an adjustment width of the surface resistivity of the glass substrate 15 for electronic amplification can be widened, and the insulation resistance of the glass substrate 15 for electronic amplification can further surely fall in the range of 10⁷ to 10¹¹ Ω.

Further, in this embodiment, the photosensitive glass is used as the material of the glass member of the plate-like member 11, and therefore the plate-like member 11 has excellent heat resistance, smoothness, and rigidity, etc. , compared with the case of using the resin material such as polyimide, etc., and there is no problem of the outgas. Further, a fine processing technique used in a semiconductor manufacturing process can be utilized, and therefore the through holes 14 having fine hole diameter and arrangement pitch, can be provided. Accordingly, the photosensitive glass used as the glass member of the plate-like member 11, is extremely suitable for constituting the substrate 10 for electronic amplification.

### <6. Modified example, etc.>

The embodiment of the present invention has been described above. However, the above-described disclosure content shows an exemplary embodiment of the present invention. Namely, a technical range of the present invention is not limited to the above-described exemplary embodiment.

For example, the above-described embodiment shows a case that the substrate 10 for electronic amplification in the chamber 2 is only one for example. However, a plurality of substrates 10 for electronic amplification may be provided in the chamber 2. In the detector 1 configured to have a plurality of substrates 10 for electronic amplification, a device structure is complicated, compared with a case of only one. However, the gain in the electron avalanche amplification can be easily increased.

Also, the above-described embodiment shows a case that the through hole 14 of the substrate 10 for electronic amplification has a round hole of a circular shape in planar view. However, the through hole 14 may have a shape capable of forming the electric field in the hole, and not the round hole but a hole of other form (such as a rectangular hole, etc.) may be acceptable.

### Examples

The present invention will be specifically described next, with reference to examples. However, it is a matter of course that the present invention is not limited to the following examples.

### (Example 1)

In example 1, the glass substrate 15 for electronic amplification was constituted, having the through holes 14 formed on the plate-like member 11 of a plate thickness of 700 µm and made of "PEG3", the through holes having a hole diameter of 140 µm and arranged at a pitch of 280 µm. As for the glass substrate 15 for electronic amplification having such a structure, the insulation resistance in the plate thickness direction per plane of 100 cm² was measured, and it was found that the glass substrate 15 had the insulation resistance of 410 MΩ when voltage of 1000V was applied thereto.

Then, the substrate 10 for electronic amplification constituted using the glass substrate 15 for electronic amplification, was disposed in the chamber 2 of the detector 1. The chamber 2 is configured so that X-ray of 6 keV is incident therein, the X-ray being collimated by 100 µmφ from an outside radiation source.

Under such a circumstance, potential difference of about 1800 V was applied between the conductive layers 12 of the substrate 10 for electronic amplification in a gas atmosphere of Ar:70%/CH₄:30%, and it was found that the electron avalanche amplification occurred in the through hole 14 without occurrence of the "discharge" and the "charge-up", and a sufficient gain, namely gain of about 10⁴ could be obtained.

### (Example 2)

In example 2, the glass substrate 15 for electronic amplification made of "PEG3C" was constituted, having the through holes 14 formed on the plate-like member 11 of a plate thickness of 840 µm and made of "PEG3C", the through holes having a hole diameter of 140 µm and arranged at a pitch of 280 µm. Then, etching treatment was applied to the glass substrate 15 for electronic amplification by an etching solution in which NH4F/HF and (NH4)2SO4 were mixed for 35 minutes, to thereby roughen the inner wall surface of the through hole 14. As for the glass substrate 15 for electronic amplification having such a structure, the insulation resistance in the plate thickness direction per plane of 100 cm² was measured, and it was found that the glass substrate 15 had the insulation resistance of 450 MΩ when voltage of 1000V was applied thereto.

Then, the substrate 10 for electronic amplification constituted using the glass substrate 15 for electronic amplification having the abovementioned structure, was disposed in a similar state as the case of example 1, and potential difference of about 1800V was applied between the conductive layers 12 in a gas atmosphere of Ar:70%/CH4:30%. Then, it was found that the electron avalanche amplification occurred in the through hole 14 without occurrence of the "discharge" and the "charge-up", and a sufficient gain, namely gain of about 10⁴ was obtained at the time of the electron avalanche amplification.

### (Comparative example 1)

In comparative example 1, the substrate was constituted, having the through holes formed on the plate-like member of a plate thickness of 50 µm and made of "polyimide" which is a resin material, the through holes having a hole diameter of 140 µm and arranged at a pitch of 280 µm, as a replacement of the glass substrate 15 for electronic amplification. As for such a replacement substrate having such a structure, the insulation resistance in the plate thickness direction per plane of 100 cm² was measured, and it was found that the substrate had the insulation resistance exceeding 100 GΩ when voltage of 500V was applied thereto.

Then, the substrate 10 for electronic amplification constituted using the replacement substrate, was disposed in a similar state as the case of example 1, and potential difference of about 500V was applied between the conductive layers 12 in a gas atmosphere of Ar:70%/CH₄:30%. Then, it was found that only the gain of about 3000 could be obtained.

### (Comparative example 2)

In comparative example 2, the glass substrate 15 for electronic amplification was constituted, having the through holes formed on the plate-like member 11 of a plate thickness of 700 µm and made of "SD2" which is a glass material, the through holes having a diameter of 140 µm and arranged at pitch of 280 µm. As for the glass substrate 15 for electronic amplification having such a structure, the insulation resistance in the plate thickness direction per plane of 100 cm² was measured, and it was found that the insulation resistance was less than 10 MΩ.

Then, the substrate 10 for electronic amplification thus constituted using the glass substrate 15 for electronic amplification, was disposed under the same circumstance as the case of example 1, and potential difference of about 1800V was applied between the conductive layers 12, and it was found that spark was generated by discharge.

### (Conclusion)

If the above-described examples 1 to 2 and comparative examples 1 and 2 are taken into consideration, it is found that if the insulation resistance in the plate thickness direction per plane of 100 cm² in the glass substrate 15 for electronic amplification, falls in the range of 10⁷ to 10¹¹ Ω, the electron avalanche amplification is caused to occur in the through hole 14 without generating neither the "discharge" nor the "charge-up", and a sufficient gain can be obtained at the time of the electron avalanche amplification.

### Description of Signs and Numerals

- 1: Detector
- 10: Substrate for electronic amplification
- 11: Plate-like member
- 14: Through hole
- 15: Glass substrate for electronic amplification

## Claims

1. A glass substrate for electronic amplification having through holes formed on a plate-like glass member and used for causing an electron avalanche in the through holes, wherein a shape of the glass substrate for electronic amplification and a material of the glass member are determined so that an insulation resistance in a plate thickness direction per plane of 100 cm² is 10⁷ to 10¹¹Ω.

2. The glass substrate for electronic amplification according to claim 1, wherein the shape is specified by at least one of the number of the through holes formed on the glass member, the hole diameter of each through hole, and a plate thickness of the glass member.

3. The glass substrate for electronic amplification according to claim 2, wherein the shape includes a state of a surface roughness on an inner wall surface of the through hole.

4. The glass substrate for electronic amplification according to claims 1, 2 or 3, wherein a photosensitive glass is used as the material of the glass member.

5. A method for manufacturing a glass substrate for electronic amplification having through holes formed on a plate-like glass member and used for causing an electron avalanche in the through holes, the method comprising:
measuring an insulation resistance value in a plate thickness direction of a measured object per plane of 100 cm² of the measured object, using a glass substrate for electronic amplification having the through holes formed on the glass member, as the measured object; and
judging a quality of the measured object whose measurement result is obtained, based on whether or not the measurement result of the insulation resistance value falls in a range of 10⁷ to 10¹¹ Ω when measuring the resistance.
